# EUROPÄISCHE PATENTSCHRIFT

(11) **EP 3 361 842 B1**
(45) Veröffentlichungstag und Bekanntmachung des Hinweises auf die Patenterteilung: **07.04.2021**
(21) Anmeldenummer: 17155517.0
(22) Anmeldetag: 10.02.2017
(51) Int. Cl.: H05K 5/00, H05K 5/02, H05K 7/14

(54) **MEDIZINISCHES REGEL- ODER STEUERGERÄT**
MEDICAL REGULATING OR CONTROLLING DEVICE
DISPOSITIF DE REGULATION OU DE CONTROLE MÉDICAL

(43) Veröffentlichungstag der Anmeldung: 15.08.2018
(73) Patentinhaber: W & H Dentalwerk Bürmoos GmbH, 5111 Bürmoos (AT)
(72) Erfinder: Schauflinger, Roland, 5301 Eugendorf (AT); EIBL, Johann, 5230 Mattighofen (AT)
(74) Vertreter: Benda, Ralf

(56) Entgegenhaltungen:
- DE-A1-102010 036 707
- DE-A1-102011 014 424
- DE-A1-102015 110 397

## Beschreibung

Die vorliegende Erfindung betrifft ein medizinisches Regel- oder Steuergerät mit einer Funktionseinheit, insbesondere einem elektronischen Modul.

Medizinische Regel- oder Steuergeräte mit einer oder mehreren Funktionseinheiten, insbesondere einem elektronischen Modul, sind heutzutage alltäglich. Zur Befestigung der Funktionseinheit in dem Regel- oder Steuergerät sind an der Funktionseinheit meist mehrere Verbindungslaschen vorgesehen, siehe zum Beispiel das Dokument US 2006/0286845 A1, Figur 2A, mittels denen die Funktionseinheit an einer geschlitzten Montageplatte befestigt wird.

Die Offenlegungsschrift DE 10 2011 014 424 A1 offenbart ein Gehäuse eines Steuergeräts mit einer Befestigungseinrichtung zum Befestigen des Gehäuses an einem Kraftwagen. Die Befestigungseinrichtung umfasst Halteteile am Gehäuse sowie Laschen, über die das Gehäuse an dem Kraftwagen befestigbar ist. Jede Lasche ist durch zwei kreuzförmig zueinander positionierte Nuten an einem Halteteil in zwei unterschiedlichen Relativstellungen an dem Gehäuse anordenbar.

Die Offenlegungsschrift DE 10 2010 036 707 A1 beschreibt ein elektronisches Gerät mit einer in einem Gehäuse angeordneten elektronischen Einrichtung. Das Gehäuse ist mittels verschiedener Befestigungslaschen auf einem Substrat befestigbar. Die Befestigungslaschen weisen unterschiedlich ausgebildete Einsteckabschnitte aus, die in Einstecktaschen im Gehäusekorpus in unterschiedlichen Positionen einsteckbar sind.

Bei der Montage von Funktionseinheiten in medizinischen Regel- oder Steuergeräten tritt wiederholt das Problem auf, dass sich aufgrund der Positionen der Verbindungslaschen an den Funktionseinheiten und aufgrund unterschiedlicher Montageplatten, zum Beispiel unterschiedlicher Abstände der Schlitze bei unterschiedlichen Montageplatten, die Module nur schwer oder nur verdreht auf den Montageplatten montieren lassen.

Der vorliegenden Erfindung liegt daher die Aufgabe zugrunde ein medizinisches Regel- oder Steuergerät zu schaffen, bei dem sich eine Funktionseinheit, insbesondere ein elektronisches Modul, einfach und in einer gewünschten Position auf einer Montageplatte, insbesondere auf unterschiedlichen Montageplatten, befestigen lässt. In entsprechender Weise soll ein verbessertes Verfahren zur Montage einer Funktionseinheit in einem medizinischen Regel- oder Steuergerät geschaffen werden.

Diese Aufgabe wird gemäß der vorliegenden Erfindung durch ein medizinisches Regel- oder Steuergerät mit den Merkmalen des Anspruchs 1 und durch ein Verfahren zur Montage einer Funktionseinheit in einem medizinischen Regel- oder Steuergerät gemäß Anspruch 13 gelöst. Besonders vorteilhafte Ausführungsformen sind in den jeweiligen Unteransprüchen angeführt.

Das medizinische Regel- oder Steuergerät umfasst eine Funktionseinheit, insbesondere ein elektronisches Modul, eine Montageplatte mit Montageöffnungen, an der die Funktionseinheit befestigbar ist, und zumindest eine Verbindungslasche mit einem Durchbruch, insbesondere einem Langloch, zum Befestigen der Funktionseinheit an der Montageplatte.

Die zumindest eine Verbindungslasche weist mehrere Verbindungselemente auf, die wahlweise mit (zumindest) einem Gegen-Verbindungselement der Funktionseinheit in Eingriff bringbar sind, wodurch die zumindest eine Verbindungslasche, insbesondere deren Durchbruch, in unterschiedlichen Orientierungen an der Funktionseinheit oder relativ zu der Funktionseinheit befestigbar ist.

Gemäß einem Ausführungsbeispiel weist die Funktionseinheit mehrere Gegen-Verbindungselemente auf, die wahlweise mit (zumindest) einem Verbindungselement der zumindest einen Verbindungslasche in Eingriff bringbar sind, wodurch die zumindest eine Verbindungslasche, insbesondere deren Durchbruch, an der Funktionseinheit an unterschiedlichen Positionen befestigbar ist.

Durch das Vorsehen mehrerer Verbindungselemente an der Verbindungslasche, die wahlweise mit einem Gegen-Verbindungselement der Funktionseinheit in Eingriff bringbar sind, ist es in vorteilhafter Weise möglich, die zumindest eine Verbindungslasche, insbesondere deren Durchbruch, vorzugsweise ein Langloch, an der Funktionseinheit in unterschiedlichen Orientierungen (relativ zur Funktionseinheit) zu befestigen. So ist es zum Beispiel denkbar, dass in einer ersten Orientierung eine Längsachse des Langlochs im Wesentlichen parallel zu einer (äußeren) Oberfläche eines Gehäuseelements oder einer Gehäusewand der Funktionseinheit anordenbar ist und in einer zweiten, alternativen Orientierung die Längsachse des Langlochs gewinkelt, vorzugsweise in etwa mit 90°, zu der genannten (äußeren) Oberfläche anordenbar ist. Alternativ oder zusätzlich ist es denkbar, dass die Verbindungslasche in einer ersten Orientierung mit einer ersten, zum Beispiel kurzen Seitenwand an einer (äußeren) Oberfläche eines Gehäuseelements oder einer Gehäusewand lagert und in einer zweiten Orientierung mit einer zweiten, zum Beispiel langen Seitenwand an der genannten (äußeren) Oberfläche lagert. Durch diese unterschiedliche Orientierungen ist es möglich, die Funktionseinheit mit der zumindest einen Verbindungslasche an unterschiedliche Montageplatten anzupassen und/ oder an einer gewünschten Position zu platzieren.

Durch das Vorsehen mehrerer Gegen-Verbindungselemente an der Funktionseinheit, die wahlweise mit einem Verbindungselement der zumindest einen Verbindungslasche in Eingriff bringbar sind, ist in vorteilhafter Weise die zumindest eine Verbindungslasche an der Funktionseinheit an unterschiedlichen Positionen (relativ zu der Funktionseinheit) befestigbar. Die Verbindungslasche kann somit zum Beispiel an oder nahe einem ersten Ende der Funktionseinheit, insbesondere eines Gehäuseelements oder einer Gehäusewand der Funktionseinheit, oder in etwa mittig in Bezug auf die Funktionseinheit, insbesondere das Gehäuseelement, oder an oder nahe einem zweiten Ende der Funktionseinheit, insbesondere des Gehäuseelements, positioniert werden. Die genannten Positionen sind selbstverständlich nur beispielhaft und es ist eine Vielzahl von anderen Positionen denkbar. Mit Hilfe dieser unterschiedlichen Positionen ist es möglich, die Funktionseinheit mit der zumindest einen Verbindungslasche an unterschiedliche Montageplatten anzupassen und/ oder an einer gewünschten Position zu platzieren.

Aus dem Vorstehenden ist klar ersichtlich, dass eine Implementierung des im Vorstehenden genannten Ausführungsbeispiels eine besonders vorteilhafte Wirkung entfaltet, weil damit sowohl die Orientierung der Verbindungslasche als auch deren Position (jeweils relativ zu der Funktionseinheit) variabel ist und somit die Funktionseinheit mit der zumindest einen Verbindungslasche an unterschiedlichste Montageplatten angepasst und/ oder an nahezu jeder gewünschten Position platziert werden kann.

Das zumindest eine Gegen-Verbindungselement ist vorzugsweise an zumindest einem Gehäuseelement, insbesondere einer Gehäusewand, der Funktionseinheit vorgesehen. Das zumindest eine Verbindungselement der zumindest einen Verbindungslasche ist somit besonders bevorzugt mit dem zumindest einen Gegen-Verbindungselement des Gehäuseelements der Funktionseinheit in Eingriff bringbar, wodurch eine besonders einfache Handhabbarkeit erreicht wird. Es ist jedoch auch denkbar, dass das zumindest eine Gegen-Verbindungselement an einem anderen Bauteil der Funktionseinheit vorgesehen ist, zum Beispiel an einem an dem Gehäuseelement gelagerten oder befestigten Bauteil.

Vorzugsweise sind bei einer Verbindungslasche mit mehreren Verbindungselementen diese derart an der Verbindungslasche angeordnet, dass nur eine Teilmenge (zumindest eines) der mehreren Verbindungselemente mit der Funktionseinheit in Eingriff bringbar ist, um die Verbindungslasche an der Funktionseinheit zu befestigen. Besonders bevorzugt sind die mehreren Verbindungselemente derart an der Verbindungslasche angeordnet, dass, während zumindest ein Verbindungselement mit der Funktionseinheit in Eingriff steht, zumindest ein anderes der mehreren Verbindungselemente nicht mit der Funktionseinheit in Eingriff steht und somit insbesondere keine Befestigung der Verbindungslasche an der Funktionseinheit bewirkt.

Vorzugsweise sind bei einer Verbindungslasche mit mehreren Verbindungselementen diese derart an der Verbindungslasche angeordnet, dass wahlweise eine erste Teilmenge (zumindest eines) der mehreren Verbindungselemente oder eine zweite, andere Teilmenge (zumindest eines) der mehreren Verbindungselemente mit der Funktionseinheit in Eingriff bringbar ist, um die Verbindungslasche an der Funktionseinheit zu befestigen. Besonders bevorzugt unterscheidet sich die Orientierung oder Anordnung der zumindest einen Verbindungslasche, insbesondere deren Durchbruch, an oder relativ zu der Funktionseinheit in Abhängigkeit davon, ob die erste oder zweite Teilmenge der mehreren Verbindungselemente der Verbindungslasche mit der Funktionseinheit in Eingriff gebracht sind. Besonders bevorzugt bewirkt jene Teilmenge, die nicht mit der Funktionseinheit in Eingriff gebracht ist, keine Befestigung der Verbindungslasche an der Funktionseinheit.

Die Funktionseinheit umfasst gemäß einem Ausführungsbeispiel zumindest ein elektronisches Modul. Das elektronische Modul ist vorzugsweise als Controller oder Mikrocontroller ausgebildet, zum Beispiel als Controller eines medizinischen oder dentalmedizinischen E-Motors oder eines medizinischen oder dentalmedizinischen Schwingungserregers, insbesondere eines Ultraschallgenerators, oder eines medizinischen HF-Generators. Die genannten Ausführungsbeispiele von elektronischen Modulen sind selbstverständlich nur beispielhaft und es sind eine Vielzahl von ähnlichen oder anderen Ausführungsbeispielen denkbar.

Ein derartiges elektronisches Modul umfasst eines oder mehrere Bauteile, zum Beispiel zumindest eine (bestückte) Leiterplatte, zumindest eine elektronische Baugruppe oder zumindest ein elektronisches Bauteil, insbesondere ein Speicherelement, einen Prozessor, einen Mikrocontroller, elektrische Leiter oder Drähte, elektronische Wandler, zum Beispiel einen Analog-Digital-Wandler, eine Strom- oder Spannungsquelle, Schaltelemente oder ähnliche Elemente. Zusätzlich oder alternativ umfasst ein elektronisches Modul zum Beispiel zumindest eine digitale oder analoge Schnittstelle oder zumindest ein Anschlusselement an ein weiteres elektronisches Modul, an eine elektrische Leitung, an ein Kabel oder an ein Bauteil außerhalb des elektronisches Modul, zum Beispiel eine Versorgungsquelle, ein elektro-mechanisches Bauteil, zum Beispiel einen Motor, ein Ventil oder eine Pumpe, oder ähnliche Elemente.

Die Funktionseinheit umfasst gemäß einem anderen Ausführungsbeispiel zumindest einen Aktor, zum Beispiel eine Pumpe, ein Ventil oder ein Relais, oder ein elektrisches Bauteil, zum Beispiel einen Transformator.

Die Funktionseinheit, insbesondere das elektronische Modul, umfasst vorzugsweise zumindest ein Gehäuseelement, besonders bevorzugt ein Gehäuse, welches die gesamte Funktionseinheit umschließt und/ oder kapselt. Das zumindest eine Gehäuseelement weist zum Beispiel eine Gehäusewand auf. Vorzugsweise bilden mehrere Gehäuseelemente ein Gehäuse. Vorzugsweise ist zumindest eines der im Vorstehenden genannten Bauteile eines elektronischen Moduls an und/ oder in dem Gehäuseelement oder Gehäuse gelagert. Vorzugsweise ist die im Vorstehenden genannte zumindest eine Schnittstelle oder das zumindest eine Anschlusselement eines elektronischen Moduls an dem Gehäuse vorgesehen.

Die Montageöffnungen der Montageplatte umfassen zum Beispiel Schlitze, insbesondere mehrere längliche Schlitze, die vorzugsweise parallel zueinander angeordnet sind, und / oder Bohrungen.

Die Verbindungslasche weist einen flächigen Körper mit mehreren gewinkelt zueinander angeordneten Umfangs- oder Seitenwänden auf. Vorzugsweise umfasst der flächige Körper eine Oberseite und eine Unterseite, welche durch die Umfangs- oder Seitenwänden miteinander verbunden sind. Vorzugsweise ist die Verbindungslasche eckig, insbesondere rechteckig, geformt. Vorzugsweise ist die Verbindungslasche plattenförmig oder quaderförmig geformt. Vorzugsweise weisen die gewinkelt zueinander angeordneten Umfangs- oder Seitenwände unterschiedliche Längen oder Kantenlängen auf.

Die mehreren Verbindungselemente sind an zumindest zwei gewinkelt zueinander angeordneten Umfangs- oder Seitenwänden vorgesehen. Vorzugsweise ist an zwei unterschiedlichen der mehreren gewinkelt zueinander angeordneten Umfangs- oder Seitenwänden zumindest jeweils ein Verbindungselemente angeordnet. Besonders bevorzugt sind jeweils zwei Verbindungselemente an zwei (unterschiedlichen) der mehreren gewinkelt zueinander angeordneten Umfangs- oder Seitenwänden vorgesehen.

Besonders bevorzugt weisen jene zwei Seitenwände, an denen jeweils zumindest ein Verbindungselement vorgesehen ist, unterschiedliche Längen auf, zum Beispiel gibt es eine Seitenwand mit einer kurzen Seitenlänge und eine Seitenwand mit einer langen Seitenlänge, an denen jeweils zumindest ein Verbindungselement angeordnet ist. Besonders bevorzugt unterscheidet sich die Orientierung oder Anordnung der zumindest einen Verbindungslasche, insbesondere deren Durchbruch, an oder relativ zu der Funktionseinheit in Abhängigkeit davon, ob das an der Seitenwand mit der kurzen Seitenlänge angeordnete zumindest eine Verbindungselement oder das an der Seitenwand mit der langen Seitenlänge angeordnete zumindest eine Verbindungselement mit der Funktionseinheit in Eingriff ist und / oder ob das an der Seitenwand mit der kurzen Seitenlänge angeordnete zumindest eine Verbindungselement oder das an der Seitenwand mit der langen Seitenlänge angeordnete zumindest eine Verbindungselement nicht mit der Funktionseinheit in Eingriff ist.

Die Verbindungslasche ist mit zumindest einem Durchbruch oder einer Bohrung versehen. Vorzugsweise ist der zumindest eine Durchbruch als Langloch ausgebildet. Vorzugsweise ist der zumindest eine Durchbruch zur Aufnahme eines Verbindungsteil, zum Beispiel einer Schraube, einer Niete, eines Bolzens oder eines ähnlichen stiftförmigen Elements, zur Verbindung mit der Montageplatte, insbesondere mit deren Montageöffnungen, vorgesehen. Vorzugsweise ragt dieses Verbindungsteil zur Befestigung der Funktionseinheit an der Montageplatte durch den Durchbruch in eine Montageöffnung der Montageplatte und verbindet und/ oder fixiert die Funktionseinheit an der Montageplatte. Vorzugsweise durchsetzt der Durchbruch den Körper der Verbindungslasche von dessen Oberseite zu dessen Unterseite. Vorzugsweise ist der Durchbruch zentral in der Verbindungslasche oder deren Körper angeordnet. Selbstverständlich ist es aber auch möglich, den Durchbruch exzentrisch oder versetzt in der Verbindungslasche oder deren Körper anzuordnen.

Vorzugsweise ist das zumindest eine Verbindungselement einteilig mit der Verbindungslasche oder deren Körper ausgebildet. Vorzugsweise erstreckt sich das zumindest eine Verbindungselement von einer Umfangs- oder Seitenwand der Verbindungslasche. Vorzugsweise umfasst das zumindest eine Verbindungselement ein Steck- oder Klemmelement, zum Beispiel, einen Haken, Stift, Fortsatz oder ähnliches. Vorzugsweise weist das Steck- oder Klemmelemente eine Nase oder einen Vorsprung zum Hintergreifen zumindest eines Teils eines Gegen-Verbindungselements der Funktionseinheit auf. Vorzugsweise ist das zumindest eine Verbindungselement als federndes Steck- oder Klemmelement ausgebildet.

Alternativ umfasst das zumindest eine Verbindungselement der Verbindungslasche, das vorzugsweise als Steck- oder Klemmelemente ausgebildet ist, eine Öffnung oder Aufnahme zum Aufnehmen eines Gegen-Verbindungselements der Funktionseinheit. Vorzugsweise ist die Öffnung oder Aufnahme in einer Umfangs- oder Seitenwand der Verbindungslasche oder dem Körper der Verbindungslasche geformt.

Vorzugsweise ist die Öffnung oder Aufnahme eckig, insbesondere rechteckig, geformt. Vorzugsweise ist eine Seitenkante der Öffnung oder Aufnahme nicht länger als 1 mm, 2 mm, 3 mm, 4 mm oder 5 mm. Vorzugsweise ist die Öffnung oder Aufnahme derart bemessen, dass (nur) ein einziges Gegen-Verbindungselement der Funktionseinheit darin aufnehmbar ist. Alternativ ist es auch denkbar, dass die Öffnung oder Aufnahme derart bemessen ist, dass mehr als ein einziges Gegen-Verbindungselement der Funktionseinheit darin aufnehmbar ist, besonders bevorzugt zwei Gegen-Verbindungselemente darin aufnehmbar sind.

Vorzugsweise beträgt der Abstand zwischen zwei benachbarten Verbindungselementen maximal einen, zwei, drei, vier oder fünf Millimeter.

Vorzugsweise ist das zumindest eine Gegen-Verbindungselement einteilig mit der Funktionseinheit, insbesondere dem Gehäuseelement, ausgebildet. Vorzugsweise umfasst das zumindest eine Gegen-Verbindungselement ein Steck- oder Klemmelement. Besonders bevorzugt umfasst das zumindest eine Gegen-Verbindungselement eine Öffnung oder eine Aufnahme zum Aufnehmen zumindest eines Verbindungselements der Verbindungslasche, insbesondere eines im Vorstehenden beschriebenen Verbindungselements der Verbindungslasche. Vorzugsweise ist das Gegen-Verbindungselement, insbesondere die Öffnung oder Aufnahme, in dem Gehäuseelement der Funktionseinheit geformt.

Vorzugsweise ist die Öffnung oder Aufnahme eckig, insbesondere rechteckig, geformt. Vorzugsweise ist eine Seitenkante der Öffnung oder Aufnahme nicht länger als 1 mm, 2 mm, 3 mm, 4 mm oder 5 mm. Vorzugsweise ist die Öffnung oder Aufnahme derart bemessen, dass (nur) ein einziges Verbindungselement der Verbindungslasche darin aufnehmbar ist. Alternativ ist es auch denkbar, dass die Öffnung oder Aufnahme derart bemessen ist, dass mehr als ein einziges Verbindungselement der Verbindungslasche darin aufnehmbar ist, besonders bevorzugt zwei Verbindungselemente darin aufnehmbar sind.

Alternativ ist es auch denkbar, dass das zumindest eine Gegen-Verbindungselement ein Steck- oder Klemmelement in Form eines Hakens, Stifts, Fortsatzes oder ähnliches aufweist. Vorzugsweise umfasst dieses Steck- oder Klemmelement eine Nase oder einen Vorsprung zum Hintergreifen zumindest eine Teils eines Verbindungselements der zumindest einen Verbindungslasche. Vorzugsweise ist das Gegen-Verbindungselement als federndes Steck- oder Klemmelemente ausgebildet.

Vorzugsweise sind das zumindest eine Verbindungselement und das zumindest eine Gegen-Verbindungselement lösbar miteinander verbindbar, wodurch in vorteilhafter Weise eine inkorrekte Verbindung der Verbindungslasche mit der Funktionseinheit, zum Beispiel während der Montage, rückgängig gemacht werden kann.

Vorzugsweise sind das zumindest eine Verbindungselement und das zumindest eine Gegen-Verbindungselement reibschlüssig und/ oder formschlüssig, insbesondere komplementär zueinander, ausgebildet, wodurch eine besonders zuverlässige Befestigung der Verbindungslasche an der Funktionseinheit erzielbar ist. Besonders bevorzugt bildet das zumindest eine Verbindungselement der zumindest einen Verbindungslasche und das zumindest eine Gegen-Verbindungselement der Funktionseinheit eine mechanische Verbindungsvorrichtung, insbesondere eine Steck- oder Klemmvorrichtung. Vorzugsweise ist die mechanische Verbindungsvorrichtung vorgesehen, die zumindest eine Verbindungslasche an der Funktionseinheit, insbesondere an einem Gehäuseelement der Funktionseinheit, zu befestigen.

Besonders bevorzugt ist an der Funktionseinheit, insbesondere an einem Gehäuseelement der Funktionseinheit, eine Vielzahl von Gegen-Verbindungselemente vorgesehen. Damit erhöht sich in vorteilhafter Weise die Flexibilität oder Variabilität enorm, so dass die Funktionseinheit mit der zumindest einen Verbindungslasche an jegliche Montageplatte angepasst und/ oder an oder in nahezu jeder gewünschten Position platziert werden kann.

Vorzugsweise sind die Gegen-Verbindungselemente entlang einer Geraden und/ oder entlang einer Kante der Funktionseinheit und/ oder entlang einer Gehäusekante eines Gehäuseelements der Funktionseinheit angeordnet. Vorzugsweise sind die Gegen-Verbindungselemente entlang eines Großteils der Kante oder Gehäusekante angeordnet, zum Beispiel sind die Gegen-Verbindungselemente entlang zumindest 50% oder 75% der Gesamtlänge der Kante oder Gehäusekante angeordnet.

Vorzugsweise sind an der Funktionseinheit, insbesondere an einem Gehäuseelement der Funktionseinheit, zumindest zwei, drei, vier, fünf, sechs, sieben, acht, neun, zehn, mehr als zehn oder zumindest fünfzehn Gegen-Verbindungselemente angeordnet, insbesondere entlang einer Geraden und/ oder entlang einer Kante der Funktionseinheit und/ oder entlang einer Gehäusekante eines Gehäuseelements der Funktionseinheit.

Vorzugsweise beträgt der Abstand zwischen zwei benachbarten Gegen-Verbindungselementen maximal einen, zwei, drei, vier oder fünf Millimeter.

Vorzugsweise umfasst die Funktionseinheit eine Vielzahl von Gegen-Verbindungselementen, die an zumindest zwei unterschiedlichen, insbesondere einander gegenüber liegenden, Gehäuseelementen oder Gehäusewänden der Funktionseinheit angeordnet sind. Damit wird in vorteilhafter Weise eine sehr zuverlässige Befestigung der Funktionseinheit an der Montageplatte erreicht. Besonders bevorzugt sind an jedem der zwei unterschiedlichen Gehäuseelemente mehrere Gegen-Verbindungselemente vorgesehen, so wie dies im Vorstehenden beschrieben ist.

Vorzugsweise ist/ sind die zumindest eine Verbindungslasche und/ oder das Gehäuseelement der Funktionseinheit aus Kunststoff gefertigt, zum Beispiel aus Polycarbonat, Polyethylen oder aus Acrylnitril-Styrol-Acrylester (ASA) oder aus Mischungen davon. Vorzugsweise sind die zumindest eine Verbindungslasche und/ oder das Gehäuseelement durch Spritzgießen oder durch ein Druckverfahren hergestellt. Vorzugsweise sind das Gehäuseelement mit dem zumindest einen Gegen-Verbindungselement und die zumindest eine Verbindungslasche mit dem zumindest einen Verbindungselement als ein einziges, gemeinsames, insbesondere miteinander verbundenes Werkstück hergestellt.

Gemäß einem Ausführungsbeispiel ist eine medizinische, insbesondere dentalmedizinische Behandlungsvorrichtung vorgesehen, die ein im Vorstehenden beschriebenes medizinisches Regel- oder Steuergerät aufweist. Die Behandlungsvorrichtung umfasst zum Beispiel: eine dentale Behandlungseinheit mit einem Behandlungsstuhl und einem oder mehreren Handstücken zur Behandlung eines Patienten; ein dentales Tischgerät mit zumindest einem Handstück zur Behandlung eines Patienten; eine medizinische oder chirurgische Behandlungseinheit für HF-Anwendungen, laparoskopische oder endoskopische Anwendungen; eine medizinische, dentalmedizinische oder chirurgische Behandlungseinheit mit einer Ultraschallquelle oder einer Laserquelle; eine medizinische oder chirurgische Behandlungseinheit mit einer Kamera- und/ oder Beleuchtungseinheit. Die genannten Behandlungsvorrichtungen sind selbstverständlich nur beispielhaft und es ist eine Vielzahl von anderen Behandlungsvorrichtungen denkbar.

Die medizinische, insbesondere dentalmedizinische Behandlungsvorrichtung umfasst zum Beispiel zumindest eines der folgenden Bauteile: einen Antrieb, insbesondere einen E-Motor oder einen Ultraschallgenerator; zumindest ein Stellelement zum Einstellen oder Auswählen eines Betriebsparameters durch den Anwender; eine Anzeigevorrichtung zum Anzeigen eines Betriebsparameters; eine Fördereinheit zum Fördern eines Betriebs- oder Kühlmediums.

Die medizinische, insbesondere dentalmedizinische Behandlungsvorrichtung weist ein Gehäuse auf, in oder an dem das zumindest eine im Vorstehenden genannte Bauteil und die Funktionseinheit, insbesondere das elektronische Modul, angeordnet sind. In dem Gehäuse oder als Teil des Gehäuses ist auch die Montageplatte mit den Montageöffnungen vorgesehen, an der die Funktionseinheit, insbesondere das elektronische Modul, mit der zumindest einen Verbindungslasche wie im Vorstehenden beschrieben befestigbar oder befestigt ist.

Vorzugsweise ist die Funktionseinheit, insbesondere das elektronische Modul, mit zumindest einem Bauteil der Behandlungsvorrichtung, insbesondere einem der im Vorstehenden genannte Bauteile, elektrisch und/ oder kommunikativ verbunden. Besonders bevorzugt sendet und/ oder empfängt die Funktionseinheit, insbesondere das elektronische Modul, elektrische Signale und/ oder elektrische Versorgungsenergie an ein Bauteil der medizinische, insbesondere dentalmedizinische Behandlungsvorrichtung.

Besonders bevorzugt sind an dem Gehäuse oder Gehäuseelement der Funktionseinheit, insbesondere des elektronischen Moduls, Anschlusselemente zur elektrischen und/ oder kommunikativen Verbindung mit zumindest einem Bauteil der Behandlungsvorrichtung vorgesehen, zum Beispiel mechanische Klemmen oder Stecker. Selbstverständlich sind an dem Gehäuse oder Gehäuseelement auch Steckelemente zur Energieversorgung der Funktionseinheit, insbesondere des elektronischen Moduls, vorgesehen, so dass die Funktionseinheit mit einer elektrischen Energiequelle verbindbar ist.

Das Verfahren zur Montage einer Funktionseinheit, insbesondere eines elektronischen Moduls, an einer Montageplatte mit Montageöffnungen eines medizinischen Regel- oder Steuergerät mittels zumindest einer Verbindungslasche ist dadurch definiert, dass die zumindest eine Verbindungslasche mehrere Verbindungselemente aufweist, wobei wahlweise zumindest eines der mehreren Verbindungselemente mit einem Gegen-Verbindungselement der Funktionseinheit in Eingriff gebracht wird, so dass die Verbindungslasche an der Funktionseinheit befestigt ist, während zumindest ein anderes der mehreren Verbindungselemente nicht mit der Funktionseinheit, insbesondere nicht mit einem Gegen-Verbindungselement der Funktionseinheit, in Eingriff steht, und dass die Funktionseinheit mittels der Verbindungslasche an der Montageplatte befestigt wird.

Ein Ausführungsbeispiel des Verfahrens zur Montage einer Funktionseinheit, insbesondere eines elektronischen Moduls, an einer Montageplatte mit Montageöffnungen eines medizinischen Regel- oder Steuergerät mittels zumindest einer Verbindungslasche ist dadurch definiert, dass die Funktionseinheit mehrere Gegen-Verbindungselemente aufweist, wobei wahlweise zumindest eines der mehreren Gegen-Verbindungselemente mit einem Verbindungselement der Verbindungslasche in Eingriff gebracht wird, so dass die Verbindungslasche an der Funktionseinheit befestigt ist, während zumindest ein anderes der mehreren Gegen-Verbindungselemente nicht mit der Verbindungslasche, insbesondere nicht mit einem Verbindungselement der Verbindungslasche, in Eingriff steht, und dass die Funktionseinheit mittels der Verbindungslasche an der Montageplatte befestigt wird.

In dem Montageverfahren kommen insbesondere die im Vorstehenden beschriebenen medizinischen Regel- oder Steuergeräte, Funktionseinheiten, insbesondere elektronischen Module und Verbindungslaschen zur Anwendung.

Vorzugsweise werden die Verbindungselemente der zumindest einen Verbindungslasche durch Stecken oder Klemmen mit dem oder den Gegen-Verbindungselement(en) in Eingriff gebracht. Vorzugsweise wird die Funktionseinheit mit einem die Verbindungslasche, insbesondere den Durchbruch, durchsetzenden Verbindungsteil, zum Beispiel einer Schraube, einer Niete, einem Bolzen oder einem ähnlichen stiftförmigen Element, an der Montageplatte, insbesondere an deren Montageöffnungen, befestigt.

Ein Verfahren zur Herstellung eines Gehäuseelements einer Funktionseinheit, insbesondere eines elektronischen Moduls, und zumindest einer Verbindungslasche mit einem Durchbruch zur Verbindung der Funktionseinheit mit einer Montageplatte mit Montageöffnungen eines medizinischen Regel- oder Steuergeräts, wobei die zumindest eine Verbindungslasche zumindest ein Verbindungselement und das Gehäuseelement zumindest ein Gegen-Verbindungselement aufweist, die wahlweise miteinander in Eingriff bringbar sind und wobei das Gehäuseelement und die zumindest eine Verbindungslasche aus Kunststoff hergestellt werden, umfasst folgende Schritte: das Gehäuseelement mit dem zumindest einen Gegen-Verbindungselement und die zumindest eine Verbindungslasche mit dem zumindest einen Verbindungselement werden als ein gemeinsames, insbesondere miteinander verbundenes Werkstück hergestellt, zum Beispiel durch Spritzgießen oder Ausdrucken, und anschließend werden das Gehäuseelement mit dem zumindest einen Gegen-Verbindungselement und die zumindest eine Verbindungslasche mit dem zumindest einen Verbindungselement voneinander getrennt.

Vorzugsweise werden das Gehäuseelement und die Verbindungslasche im Wesentlichen gleichzeitig hergestellt. Vorzugsweise werden das Gehäuseelement und die Verbindungslasche aus Polycarbonat, Polyethylen oder aus Acrylnitril-Styrol-Acrylester (ASA) oder aus Mischungen davon hergestellt. Vorzugsweise werden das Gehäuseelement und die Verbindungslasche in einer gemeinsamen Spritzguss-Form hergestellt. Vorzugsweise werden das Gehäuseelement mit dem zumindest einen Gegen-Verbindungselement und die zumindest eine Verbindungslasche mit dem zumindest einen Verbindungselement durch Brechen voneinander getrennt.

Vorzugsweise werden das im Vorstehenden beschriebene Verfahren zur Montage einer Funktionseinheit und das Verfahren zur Herstellung eines Gehäuseelements einer Funktionseinheit und zumindest einer Verbindungslasche in einem Verfahren zur Herstellung eines medizinischen Regel- oder Steuergeräts zusammengefasst oder gemeinsam, insbesondere aufeinanderfolgend, angewendet.

Die Erfindung wird nachfolgend anhand bevorzugter Ausführungsbeispiele und Bezug nehmend auf die beigefügten Zeichnungen erläutert:
Figur 1 zeigt ein Ausführungsbeispiel einer Funktionseinheit in Form eines elektronischen Moduls;
Figur 2 zeigt ein Ausführungsbeispiel einer Verbindungslasche mit mehreren Verbindungselementen;
Figur 3 zeigt ein Gehäuseelement einer Funktionseinheit und zwei Verbindungslaschen, die als ein gemeinsames Werkstück hergestellt sind;
Figur 4 zeigt eine Außenansicht einer medizinischen, insbesondere dentalmedizinischen Behandlungsvorrichtung mit einem Antrieb und einem Regel- oder Steuergerät;
Figur 5 zeigt die medizinische, insbesondere dentalmedizinische Behandlungsvorrichtung der Figur 4 mit geöffnetem Gehäuse, in dem eine Funktionseinheit in Form eines elektronischen Moduls, das auf einer Montageplatte mit Montageöffnungen befestigt ist, angeordnet ist.

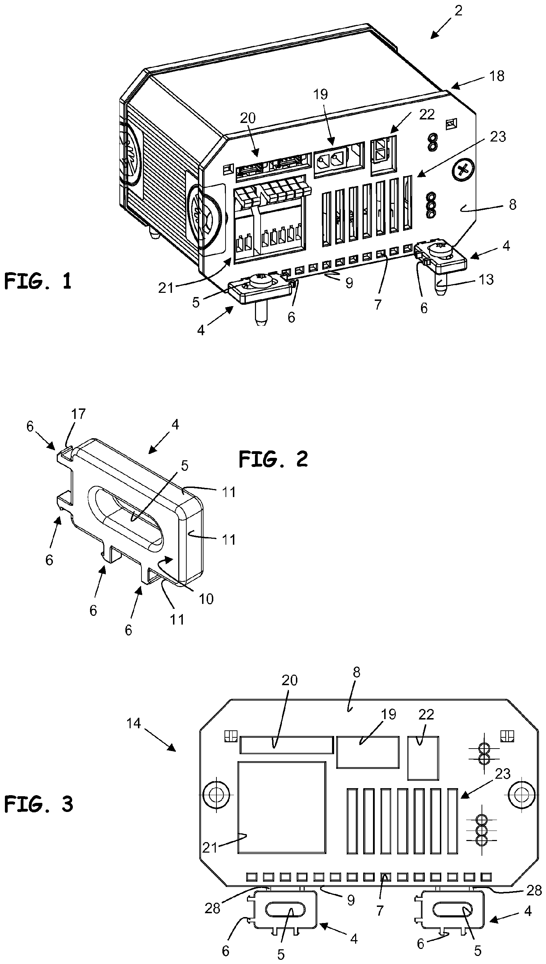

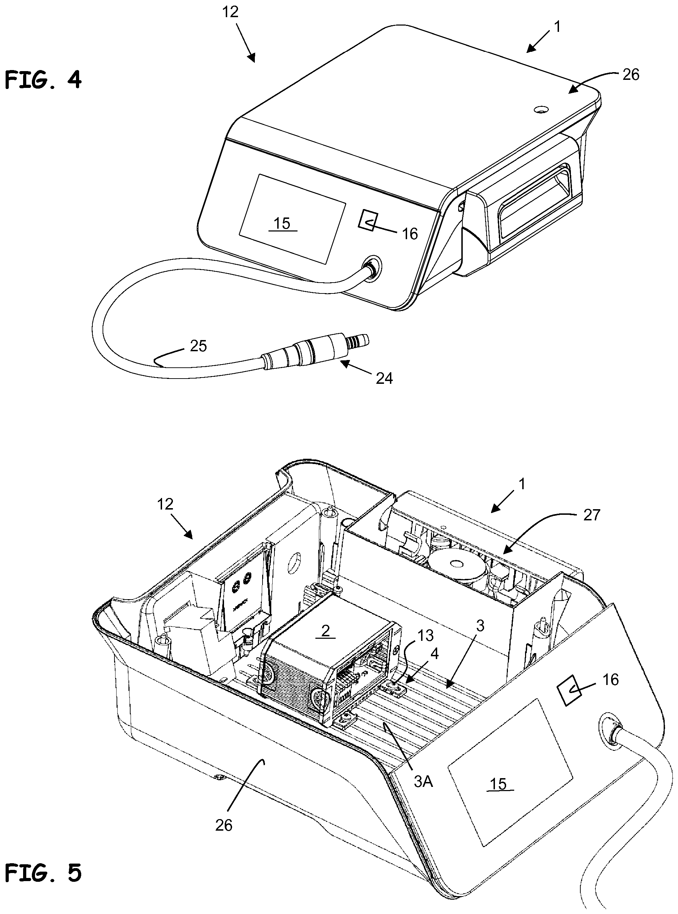

Die in der Figur 1 dargestellte Funktionseinheit 2 eines medizinischen Regel- oder Steuergeräts 1 (Figur 4) ist als ein elektronisches Modul ausgebildet, zum Beispiel als Motorcontroller eines medizinischen oder dentalmedizinischen E-Motors oder Controller eines medizinischen oder dentalmedizinischen Ultraschallgenerators.

Die Funktionseinheit 2 umfasst ein aus mehreren Gehäuseelementen 8 bestehendes Gehäuse 18, in dem zumindest eine Leiterplatte oder Platine angeordnet ist. Die Leiterplatte ist in bekannter Weise mit elektronischen Bauteilen bestückt, welche die Steuerung oder Regelung des E-Motors oder Ultraschallgenerators bewirken. Bevorzugt ist in dem Gehäuse 18 zumindest noch eine weitere Leiterplatte vorgesehen, die zum Beispiel zur Steuerung oder Regelung einer Anzeigevorrichtung 15 des medizinischen Regel- oder Steuergeräts 1, zum Betrieb eines Stellelements 16 für den Anwender und zur Verarbeitung von von dem Stellelement 16 empfangenen Stellsignalen, zur Steuerung oder Regelung weiterer Baugruppen des medizinischen Regel- oder Steuergeräts 1, zum Beispiel einer Pumpe oder eines Ventils, oder ähnlichem vorgesehen ist.

Die Funktionseinheit 2 (das elektronische Modul) ist an einer Montageplatte 3 mit Montageöffnungen in Form einer Vielzahl von parallel verlaufender Schlitze 3A (siehe Figur 5) des Regel- oder Steuergeräts 1 befestigt und innerhalb des Gehäuses 18 positioniert. Dazu ist/ sind an der Funktionseinheit 2, insbesondere an zumindest einem Gehäuseelement 8, eine oder mehrere Verbindungslaschen 4 mit jeweils einem Durchbruch 5 vorgesehen. Jeder Durchbruch 5 ist von einer Schraube 13 (oder einem ähnlichen Befestigungsmittel) durchsetzt, welche in die Schlitze 3A eingreift und die Funktionseinheit 2 damit an der Montageplatte 3 befestigt.

In der Figur 2 ist eine Verbindungslasche 4 mit einem Durchbruch 5, insbesondere in Form eines Langlochs, zum Befestigen der Funktionseinheit 2 an der Montageplatte 3 dargestellt: die Verbindungslasche 4 weist einen flächigen, im Wesentlichen rechteckigen Körper 10 mit mehreren gewinkelt zueinander angeordneten Seitenwänden 11 auf. Zentral im Körper 10 ist der als Langloch ausgebildete Durchbruch 5 angeordnet. Aufgrund der rechteckigen Form des Körpers 10 weist die Verbindungslasche jeweils zwei lange und zwei kurze Seitenwände 11 auf. An einer der beiden kurzen Seitenwände 11 und an einer der beiden langen Seitenwände 11 sind jeweils zwei Verbindungselemente 6 angeordnet.

Jedes Verbindungselement 6 erstreckt sich von der jeweiligen Seitenwand 11 und ist einteilig mit dem Körper 10 der Verbindungslasche 4 ausgebildet. Jedes Verbindungselement 6 ist als stiftförmiges Steck- oder Klemmelement geformt, das an seinem freien Ende eine Rastnase 17 zum Hintergreifen eines an der Funktionseinheit 2 angeordneten Gegen-Verbindungselements 7 vorgesehen ist.

Mit Hilfe der Verbindungselemente 6 ist die Verbindungslasche 4 an der Funktionseinheit 2, insbesondere an dem Gehäuseelement 8, befestigbar. Dazu sind an der Funktionseinheit 2, insbesondere an dem Gehäuseelement 8, mehrere Gegen-Verbindungselemente 7 vorgesehen, die entlang der Gehäusekante 9 an einer Geraden angeordnet sind. Die Gegen-Verbindungselemente 7 sind als Steck- oder Klemmelement in Form von Aufnahmen oder Rücksprünge ausgebildet, in welche die Verbindungselemente 6 der Verbindungslasche 4 eingreifen oder einrasten.

Wie insbesondere aus der Figur 1 zu erkennen ist, ermöglicht die große Anzahl an Gegen-Verbindungselementen 7 die Verbindungslasche 4 wahlweise an unterschiedlichen Positionen an der Funktionseinheit 2, insbesondere an dem Gehäuseelement 8, zu befestigen. In der Figur 1 sind die beiden Verbindungslaschen 4 jeweils an den äußersten Gegen-Verbindungselementen 7 befestigt, es wäre jedoch zum Beispiel auch möglich zumindest eine der beiden Verbindungslaschen 4 zentraler oder in der Mitte des Gehäuseelements 8 anzuordnen.

Aus der Figur 1 ist auch zu erkennen, dass aufgrund der Anordnung von jeweils zwei Verbindungselementen 6 an einer der beiden kurzen Seitenwände 11 und an einer der beiden langen Seitenwände 11 die Verbindungslasche 4 bzw. der Durchbruch 5 wahlweise in unterschiedlichen Orientierungen an der Funktionseinheit 2, insbesondere an dem Gehäuseelement 8, befestigbar ist. Die in der Figur 1 links dargestellte Verbindungslasche 4 lagert mit ihrer langen Seitenwand 11 an der Funktionseinheit 2, während die rechts dargestellte Verbindungslasche 4 die Funktionseinheit 2 mit ihrer kurzen Seitenwand 11 kontaktiert. Entsprechend erstreckt sich die Längsachse des Langlochs 5 der linken Verbindungslasche 4 im Wesentlichen parallel zu eine äußeren Oberfläche des Gehäuseelements 8, während die Längsachse des Langlochs 5 der rechten Verbindungslasche 4 im Wesentlichen rechtwinkelig zu der äußeren Oberfläche des Gehäuseelements 8 angeordnet ist.

Die unterschiedlichen Positionierungs- und Orientierungsmöglichkeiten der Verbindungslaschen 4 an der Funktionseinheit 2 bewirken eine hohe Flexibilität in Bezug auf die Positionierung und Anordnung der Funktionseinheit 2 in dem Gehäuse 18 des Regel- oder Steuergeräts 1. Damit ist eine möglichst kompakte und Platz sparende Anordnung der Funktionseinheit 2 (des elektronischen Moduls) und weiterer Bauteile in dem Gehäuse 18 möglich. Die hohe Flexibilität in Bezug auf die Positionierung und Anordnung erleichtert auch die Befestigung der Funktionseinheit 2 an unterschiedliche Arten von Montageplatten 3, die sich zum Beispiel im Abstand oder Form ihrer Montageöffnungen, insbesondere der Schlitze 3A, unterscheiden.

In der Figur 1 ist nur ein Gehäuseelement 8 mit Gegen-Verbindungselementen 7 erkennbar. Bevorzugt weist die Funktionseinheit 2 zumindest ein weiteres Gehäuseelement 8 auf, das ebenfalls mehrere Gegen-Verbindungselemente 7 umfasst und an denen wie im Vorstehenden beschrieben an unterschiedlichen Positionen und in unterschiedlichen Orientierungen zumindest eine weitere Verbindungslasche 4 befestigbar ist. Damit ist die Funktionseinheit 2 an zumindest zwei unterschiedlichen Seiten oder über zumindest zwei Gehäuseelemente 8 an der Montageplatte 3 befestigbar. Bevorzugt sind die zwei Gehäuseelemente 8 mit den Gegen-Verbindungselementen 7 einander gegenüberliegend oder an gegenüberliegenden Enden der Funktionseinheit 2 angeordnet.

An dem Gehäuseelement 8 sind zusätzlich zu den Gegen-Verbindungselementen 7 ein oder mehrere weitere Elemente vorgesehen, zum Beispiel: Öffnungen und/ oder Anschlüsse 19, zum Beispiel Buchsen oder Stecker, für die elektrische Energieversorgung der Funktionseinheit 2, über welche die Funktionseinheit 2 mit einer elektrischen Energiequelle verbindbar ist; Öffnungen und/ oder Anschlüsse 20, zum Beispiel Buchsen oder Stecker, für eine Datenübertragung oder kommunikative Verbindung der Funktionseinheit 2 mit einem Bauteil außerhalb der Funktionseinheit 2, insbesondere für eine Bus-Verbindung; Öffnungen und/ oder Anschlüsse 21, zum Beispiel mechanische Klemmen, zur Verbindung mit einem Instrument, zum Beispiel einem E-Motor oder einem Ultraschallgenerator; Öffnungen und/ oder Anschlüsse 22, zum Beispiel Buchsen oder Stecker, zur Versorgung eines Bauteils außerhalb der Funktionseinheit 2, zum Beispiel einer Anzeigevorrichtung 15, mit elektrischer Energie; Lüftungsöffnungen 23.

Die Figuren 4 und 5 zeigen eine medizinische, insbesondere dentalmedizinische Behandlungsvorrichtung 12, die ein medizinisches Regel- oder Steuergerät 1 und einen an das Regel- oder Steuergerät 1 angeschlossenen E-Motor 24 aufweist. Der E-Motor 24 ist über ein Kabel 25 mit mehreren Drähten oder Leitungen mit dem Regel- oder Steuergerät 1 und insbesondere über die mechanischen Klemmen 21 mit dem als Motorcontroller ausgebildeten elektronischen Modul 2 verbunden. Das elektronische Modul 2 steuert oder regelt somit den Betrieb des E-Motors 24. Der E-Motor 24 weist ein Kupplungselement zur lösbaren Verbindung mit einem medizinischen oder dentalmedizinischen Instrument, zum Beispiel einem Handstück, auf.

An der Behandlungsvorrichtung 12 ist des Weiteren eine Anzeigevorrichtung 15 vorgesehen, die zum Beispiel Betriebsparameter des E-Motors 24 anzeigt. Die Anzeigevorrichtung 15 ist über die Anschlüsse 22 zur Versorgung mit elektrischer Energie und über die Anschlüsse 20 kommunikativ mit dem elektronische Modul 2 verbunden. Das elektronische Modul 2 steuert oder regelt somit die Anzeigevorrichtung 15 und versorgt diese mit elektrischer Energie.

Schließlich ist an der Behandlungsvorrichtung 12 zumindest ein Stellelement 16 vorgesehen, über das ein Anwender zum Beispiel Betriebsparameter der E-Motors 24 auswählen oder einstellen kann. Auch das Stellelement 16 ist kommunikativ mit dem elektronischen Modul 2 verbunden, so dass über das Stellelement 16 eingestellte Betriebsparameter auf der Anzeigevorrichtung 15 angezeigt werden und der E-Motor 24 damit betrieben wird.

Die Figur 5 zeigt das medizinische Regel- oder Steuergerät 1 mit geöffnetem Außengehäuse 26. Im Inneren des Außengehäuses 26 ist die Montageplatte 3 mit den Montageöffnungen 3A und mit der mittels den Verbindungslaschen 4 daran befestigten Funktionseinheit 2 zu erkennen. Zusätzlich ist eine Pumpeneinheit 27 als Teil der Behandlungsvorrichtung 12 dargestellt, deren Betrieb vorzugsweise zusätzlich durch das elektronische Modul 2 gesteuert oder geregelt wird.

Die Figur 3 zeigt ein Gehäuseelement 8 mit mehreren Gegen-Verbindungselementen 7 und zwei Verbindungslaschen 4 mit jeweils mehreren Verbindungselementen 6 an unterschiedlichen Seitenwänden 11. Das Gehäuseelement 8 und die Verbindungslaschen 4 sind als ein gemeinsames Werkstück 14 aus Kunststoff hergestellt, wobei die Verbindungslaschen 4 über schmale Stege 28 mit dem Gehäuseelement 8 verbunden sind. Die Verbindungslaschen 4 sind durch Brechen der Stege 28 einfach von dem Gehäuseelement 8 trennbar und anschließend, wie im Vorstehenden beschrieben, mittels der Verbindungselemente 6 und Gegen-Verbindungselemente 7 an dem Gehäuseelement 8 befestigbar.

## Patentansprüche

1. Medizinisches Regel- oder Steuergerät (1), umfassend:
- eine Funktionseinheit (2), insbesondere ein elektronisches Modul,
- eine Montageplatte (3) mit Montageöffnungen (3A), an welcher die Funktionseinheit (2) befestigbar ist, und
- zumindest eine Verbindungslasche (4) mit einem Durchbruch (5), insbesondere einem Langloch, zum Befestigen der Funktionseinheit (2) an der Montageplatte (3), wobei die zumindest eine Verbindungslasche (4) mehrere Verbindungselemente (6) aufweist, die wahlweise mit einem Gegen-Verbindungselement (7) der Funktionseinheit (2) in Eingriff bringbar sind, wodurch die zumindest eine Verbindungslasche (4), insbesondere deren Durchbruch (5), in unterschiedlichen Orientierungen in einer Ebene an der Funktionseinheit (2) befestigbar ist, **dadurch gekennzeichnet, dass** die zumindest eine Verbindungslasche (4) einen flächigen Körper (10) mit mehreren gewinkelt zueinander angeordneten Seitenwänden (11) aufweist, wobei zumindest an zwei aneinander angrenzenden oder rechtwinkelig zueinander angeordneten Seitenwänden (11) jeweils zumindest eines der mehreren Verbindungselemente (6) angeordnet ist.

2. Medizinisches Regel- oder Steuergerät (1) nach Anspruch 1, **dadurch gekennzeichnet, dass**
die Funktionseinheit (2) mehrere Gegen-Verbindungselemente (7) aufweist, die wahlweise mit einem Verbindungselement (6) der zumindest einen Verbindungslasche (4) in Eingriff bringbar sind, wodurch die zumindest eine Verbindungslasche (4), insbesondere deren Durchbruch (5), an der Funktionseinheit (2) an unterschiedlichen Positionen befestigbar ist.

3. Medizinisches Regel- oder Steuergerät (1) nach Anspruch 1 oder 2, **dadurch gekennzeichnet, dass**
das oder die Gegen-Verbindungselement(e) (7) an zumindest einem Gehäuseelement (8) der Funktionseinheit (2) vorgesehen ist/ sind.

4. Medizinisches Regel- oder Steuergerät (1) nach Anspruch 2 oder 3, **dadurch gekennzeichnet, dass**
die mehreren Gegen-Verbindungselemente (7) entlang einer Geraden und/ oder entlang einer Kante der Funktionseinheit (2) und/ oder entlang einer Gehäusekante (9) des Gehäuseelements (8) der Funktionseinheit (2) angeordnet sind.

5. Medizinisches Regel- oder Steuergerät (1) nach Anspruch 2, 3 oder 4, **dadurch gekennzeichnet, dass**
die mehreren Gegen-Verbindungselemente (7) an zumindest zwei unterschiedlichen Gehäuseelementen (8) der Funktionseinheit (2) angeordnet sind.

6. Medizinisches Regel- oder Steuergerät (1) nach einem der vorstehenden Ansprüche, **dadurch gekennzeichnet dass**
der flächige Körper (10) eine Oberseite und eine Unterseite aufweist, welche durch die Seitenwände (11) miteinander verbunden sind.

7. Medizinisches Regel- oder Steuergerät (1) nach einem der vorstehenden Ansprüche, **dadurch gekennzeichnet, dass**
die Verbindungslasche (4) plattenförmig oder quaderförmig geformt ist.

8. Medizinisches Regel- oder Steuergerät (1) nach einem der vorstehenden Ansprüche, **dadurch gekennzeichnet, dass**
die zwei Seitenwände (11) mit dem jeweils zumindest einem Verbindungselement (6) unterschiedliche Längen aufweisen.

9. Medizinisches Regel- oder Steuergerät (1) nach einem der vorstehenden Ansprüche, **dadurch gekennzeichnet dass**
die Verbindungselemente (6) einteilig mit der Verbindungslasche (4) ausgebildet sind.

10. Medizinisches Regel- oder Steuergerät (1) nach einem der vorstehenden Ansprüche, **dadurch gekennzeichnet dass**
die Verbindungselemente (6) und das oder die Gegen-Verbindungselement(e) (7) reibschlüssig und/ oder formschlüssig, insbesondere komplementär zueinander, ausgebildet sind und/ oder Klemm- oder Steckelemente umfassen.

11. Medizinisches Regel- oder Steuergerät (1) nach einem der vorstehenden Ansprüche, **dadurch gekennzeichnet dass**
die zumindest eine Verbindungslasche (4) und/ oder das Gehäuseelement (8) der Funktionseinheit (2) aus Kunststoff gefertigt ist/ sind.

12. Medizinische, insbesondere dentalmedizinische Behandlungsvorrichtung (12), **gekennzeichnet durch**
ein medizinisches Regel- oder Steuergerät (1) nach einem der vorstehenden Ansprüche.

13. Verfahren zur Montage einer Funktionseinheit (2), insbesondere eines elektronischen Moduls, an einer Montageplatte (3) mit Montageöffnungen (3A) eines medizinischen Regel- oder Steuergerät (1) nach einem der vorstehenden Ansprüche mittels zumindest einer Verbindungslasche (4), **dadurch gekennzeichnet, dass** die zumindest eine Verbindungslasche (4) mehrere Verbindungselemente (6) aufweist, wobei wahlweise zumindest eines der mehreren Verbindungselemente (6) an einer ersten Seitenwand (11) der Verbindungslasche (4) mit einem Gegen-Verbindungselement (7) der Funktionseinheit (2) in Eingriff gebracht wird, so dass die Verbindungslasche (4) an der Funktionseinheit (2) befestigt ist, während zumindest ein anderes der mehreren Verbindungselemente (6) an einer zweiten Seitenwand (11) der Verbindungslasche (4) nicht mit der Funktionseinheit (2) in Eingriff steht, wobei die erste Seitenwand (11) und die zweite Seitenwand (11) aneinander angrenzen oder rechtwinkelig zueinander angeordnet sind, und
dass die Funktionseinheit (2) mittels der Verbindungslasche (4) an den Montageöffnungen (3A) der Montageplatte (3) befestigt wird.

14. Verfahren zur Montage einer Funktionseinheit (2) nach Anspruch 13, **dadurch gekennzeichnet, dass**
das oder die Verbindungselement(e) (6) durch Stecken oder Klemmen mit dem Gegen-Verbindungselement (7) in Eingriff gebracht wird/ werden.

15. Verfahren zur Montage einer Funktionseinheit (2) nach Anspruch 13 oder 14, **dadurch gekennzeichnet, dass**
die Funktionseinheit (2) mit einem die Verbindungslasche (4) durchsetzenden Verbindungsteil, zum Beispiel einer Schraube (13), einem Bolzen oder einer Niete, an einer Montageöffnung (3A) der Montageplatte (3) befestigt wird.

## Claims

1. A medical closed-loop or open-loop control device (1) comprising:
- a functional unit (2), in particular an electronic module,
- a mounting plate (3) having mounting openings (3A) to which the functional unit (2) can be fastened, and
- at least one connection tab (4) with an aperture (5), in particular an elongate hole, for fastening the functional unit (2) to the mounting plate (3), wherein
the at least one connection tab (4) comprises a plurality of connection elements (6) which can be brought selectively into engagement with a counter connection element (7) of the functional unit (2), so that the at least one connection tab (4), in particular its aperture (5), can be fastened to the functional unit (2) in different orientations in a plane, **characterised in that**
the at least one connection tab (4) has a flat body (10) with a plurality of side walls (11) arranged at an angle to one another, wherein at least one of the plurality of connection elements (6) is arranged on each of at least two side walls (11) which adjoin one another or are arranged at right angles to one another.

2. The medical closed-loop or open-loop control device (1) according to claim 1, **characterised in that**
the functional unit (2) comprises a plurality of counter connection elements (7) which can be brought selectively into engagement with a connection element (6) of the at least one connection tab (4), so that the at least one connection tab (4), in particular its aperture (5), can be fastened to the functional unit (2) at different positions.

3. The medical closed-loop or open-loop control device (1) according to claim 1 or 2, **characterised in that**
the counter connection element(s) (7) is/are provided on at least one housing element (8) of the functional unit (2).

4. The medical closed-loop or open-loop control device (1) according to claim 2 or 3, **characterised in that**
the plurality of counter connection elements (7) are arranged along a straight line and/or along an edge of the functional unit (2) and/or along a housing edge (9) of the housing element (8) of the functional unit (2).

5. The medical closed-loop or open-loop control device (1) according to claim 2, 3 or 4, **characterised in that**
the plurality of counter connection elements (7) are arranged on at least two different housing elements (8) of the functional unit (2).

6. The medical closed-loop or open-loop control device (1) according to one of the preceding claims, **characterised in that**
the flat body (10) has an upper side and a lower side which are connected to each other by the side walls (11).

7. The medical closed-loop or open-loop control device (1) according to one of the preceding claims, **characterised in that**
the connection tab (4) is planar or cuboidal.

8. The medical closed-loop or open-loop control device (1) according to one of the preceding claims, **characterised in that**
the two side walls (11) each with the at least one connection element (6) have different lengths.

9. The medical closed-loop or open-loop control device (1) according to one of the preceding claims, **characterised in that**
the connection elements (6) are formed in one part with the connection tab (4).

10. The medical closed-loop or open-loop control device (1) according to one of the preceding claims, **characterised in that**
the connection elements (6) and the counter connection element(s) (7) are frictionally engaged and/or force-lockingly engaged, in particular in a manner complementary to each other, and/or comprise clamping or plug-in elements.

11. The medical closed-loop or open-loop control device (1) according to one of the preceding claims, **characterised in that**
the at least one connection tab (4) and/or the housing element (8) of the functional unit (2) is/are made of plastic.

12. A medical, in particular dental treatment device (12), **characterised by** a medical closed-loop or open-loop control device (1) according to one of the preceding claims.

13. A method for mounting a functional unit (2), in particular an electronic module, on a mounting plate (3) having mounting openings (3A) of a medical closed-loop or open-loop control device (1) according to one of the preceding claims by means of at least one connection tab (4), **characterised in that**
the at least one connection tab (4) has a plurality of connection elements (6), at least one of said plurality of connection elements (6) on a first side wall (11) of the connection tab (4) being selectively engaged with a counter connection element (7) of said functional unit (2) so that the connection tab (4) is fastened to the functional unit (2), while at least one other of the plurality of connection elements (6) on a second side wall (11) of the connection tab (4) is not engaged with the functional unit (2), wherein the first side wall (11) and the second side wall (11) being adjacent to each other or arranged at right angles to each other, and
**in that** the functional unit (2) is fastened to the mounting openings (3A) of the mounting plate (3) by means of the connection tab (4).

14. The method for mounting a functional unit (2) according to claim 13, **characterised in that**
the connection element(s) (6) is/are engaged with the counter connection element (7) by plugging or clamping.

15. The method for mounting a functional unit (2) according to claim 13 or 14, **characterised in that**
the functional unit (2) is fastened to a mounting opening (3A) of the mounting plate (3) by means of a connecting part, for example a screw (13), a bolt or a rivet, which passes through the connection tab (4).

## Revendications

1. Appareil médical de régulation ou de contrôle (1), comprenant :
- une unité fonctionnelle (2), en particulier un module électronique,
- une plaque de montage (3), avec des ouvertures de montage (3A), à laquelle l'unité fonctionnelle (2) peut être fixée, et
- au moins une patte de raccordement (4) avec une ouverture (5), en particulier un trou oblong, pour fixer l'unité fonctionnelle (2) à la plaque de montage (3), dans lequel
l'au moins une patte de raccordement (4) présente plusieurs éléments de raccordement (6) qui peuvent être mis en prise, au choix, avec un élément de raccordement opposé (7) de l'unité fonctionnelle (2), moyennant quoi l'au moins une patte de raccordement (4), en particulier l'ouverture (5) de celle-ci, peut être fixée à l'unité fonctionnelle (2) dans différentes orientations dans un plan, **caractérisé en ce que**
l'au moins une patte de raccordement (4) présente un corps plat (10) avec plusieurs parois latérales (11) disposées en angle entre elles, dans lequel, au moins au niveau de deux parois latérales (11) adjacentes l'une de l'autre ou disposées en angle l'une par rapport à l'autre, respectivement au moins l'un des plusieurs éléments de raccordement (6) est disposé.

2. Appareil médical de régulation ou de contrôle (1) selon la revendication 1, **caractérisé en ce que**
l'unité fonctionnelle (2) présente plusieurs éléments de raccordement opposés (7) lesquels peuvent, au choix, être mis en prise avec un élément de raccordement (6) de l'au moins une patte de raccordement (4), moyennant quoi l'au moins une patte de raccordement (4), en particulier l'ouverture (5) de celle-ci, peut être fixée dans différentes positions à l'unité fonctionnelle (2).

3. Appareil médical de régulation ou de contrôle (1) selon la revendication 1 ou 2, **caractérisé en ce que**
le ou les élément(s) de raccordement opposé(s) (7) est/sont prévu(s) au niveau d'au moins un élément de boîtier (8) de l'unité fonctionnelle (2).

4. Appareil médical de régulation ou de contrôle (1) selon la revendication 2 ou 3, **caractérisé en ce que**
les plusieurs éléments de raccordement opposés (7) sont disposés le long d'une ligne droite et/ou le long d'un bord de l'unité fonctionnelle (2) et/ou le long d'un bord de boîtier (9) de l'élément de boîtier (8) de l'unité fonctionnelle (2).

5. Appareil médical de régulation ou de contrôle (1) selon la revendication 2, 3 ou 4, **caractérisé en ce que**
les plusieurs éléments de raccordement opposés (7) sont disposés au niveau d'au moins deux éléments de boîtier (8) différents de l'unité fonctionnelle (2).

6. Appareil médical de régulation ou de contrôle (1) selon l'une des revendications précédentes, **caractérisé en ce que**
le corps plat (10) présente une face supérieure et une face inférieure qui sont reliées ensemble par les parois latérales (11).

7. Appareil médical de régulation ou de contrôle (1) selon l'une des revendications précédentes, **caractérisé en ce que**
la patte de raccordement (4) est formée avec une forme en plaque ou une forme parallélépipédique.

8. Appareil médical de régulation ou de contrôle (1) selon l'une des revendications précédentes, **caractérisé en ce que**
les deux parois latérales (11) présentent, avec l'au moins un élément de raccordement (6) respectif, des longueurs différentes.

9. Appareil médical de régulation ou de contrôle (1) selon l'une des revendications précédentes, **caractérisé en ce que**
les éléments de raccordement (6) sont réalisés d'une seule pièce avec la patte de raccordement (4).

10. Appareil médical de régulation ou de contrôle (1) selon l'une des revendications précédentes, **caractérisé en ce que**
les éléments de raccordement (6) et le ou les élément(s) de raccordement opposé(s) (7) sont réalisés à friction entre eux et/ou à complémentarité de forme entre eux, en particulier de manière complémentaire entre eux, et/ou comprennent des éléments de serrage ou d'enfichage.

11. Appareil médical de régulation ou de contrôle (1) selon l'une des revendications précédentes, **caractérisé en ce que**
l'au moins une patte de raccordement (4) et/ou l'élément de boîtier (8) de l'unité fonctionnelle (2) est/sont fabriqué(s) en plastique.

12. Dispositif de traitement médical, en particulier de médecine dentaire (12), **caractérisé par**
un appareil médical de régulation ou de contrôle (1) selon l'une des revendications précédentes.

13. Procédé pour le montage d'une unité fonctionnelle (2), en particulier d'un module électronique, sur une plaque de montage (3) avec des ouvertures de montage (3A) d'un appareil médical de régulation ou de contrôle (1) selon l'une des revendications précédentes au moyen d'au moins une patte de raccordement (4), **caractérisé en ce que** l'au moins une patte de raccordement (4) présente plusieurs éléments de raccordement (6), dans lequel, au choix, au moins l'un des plusieurs éléments de raccordement (6) est mis en prise au niveau d'une première paroi latérale (11) de la patte de raccordement (4) avec un élément de raccordement opposé (7) de l'unité fonctionnelle (2), de sorte que la patte de raccordement (4) est fixée à l'unité fonctionnelle (2) alors qu'au moins un autre des plusieurs éléments de raccordement (6) n'est pas en prise au niveau d'une deuxième paroi latérale (11) de la patte de raccordement (4) avec l'unité fonctionnelle (2), dans lequel la première paroi latérale (11) et la deuxième paroi latérale (11) sont adjacentes l'une à l'autre ou disposées en angle droit entre elles, et
**que** l'unité fonctionnelle (2) est fixée au moyen de la patte de raccordement (4) aux ouvertures de montage (3A) de la plaque de montage (3).

14. Procédé pour le montage d'une unité fonctionnelle (2) selon la revendication 13, **caractérisé en ce que**
le ou les élément(s) de raccordement (6) est/sont mis en prise par enfichage ou serrage avec l'élément de raccordement opposé (7).

15. Procédé pour le montage d'une unité fonctionnelle (2) selon la revendication 13 ou 14, **caractérisé en ce que**
l'unité fonctionnelle (2) est fixée avec une pièce de raccordement traversant la patte de raccordement (4), par exemple une vis (13), un boulon ou un rivet, à une ouverture de montage (3A) de la plaque de montage (3).
